# EUROPÄISCHE PATENTANMELDUNG

(11) **EP 2 733 731 A1**
(43) Veröffentlichungstag der Anmeldung: **21.05.2014**
(21) Anmeldenummer: 13005078.4
(22) Anmeldetag: 24.10.2013
(51) Int. Cl.: H01L 21/67, H01L 21/677, F16F 15/023

(54) **Lagerung für eine stoßempfindliche Substratbehandlungsapparatur**

(30) Priorität: 30.10.2012 DE 102012110385
(71) Anmelder: VON ARDENNE GmbH, 01324 Dresden (DE)
(72) Erfinder: Hentschel, Michael, 01189 Dresden (DE); von der Waydbrink, Hubertus, 01326 Dresden (DE)

(57) **Zusammenfassung**

Die Erfindung betrifft den Unterbau und insbesondere die Lagerung für eine Apparatur zur Substratbehandlung. Die Apparatur ist aufgrund derer Wirkungsweise insofern stoßempfindlich, dass sich bei Schwingungen oder Stößen die substratbehandelnde Wirkung verzerrt, verfälscht oder zumindest unpräzise am Substrat niederschlägt. Derartige Probleme treten beispielsweise dort auf und lassen sich durch die Erfindung beheben, wo die Substratbehandlung mit fokussiertem Licht erfolgt.

Es ist das Ziel der Erfindung, kritische Schwingungen, die ursächlich von der Standfläche einer Apparatur herrühren, weitestgehend so zu unterdrücken, dass in der Apparatur die Lichtquelle für hochfokussiertes Linienlicht sowie das Substrat lagestabil gegenüber störenden Schwingungen behandelbar ist, sowie Aufgabe eine Apparatur mit einer verbesserter Lagerung zu schaffen.

Es kennzeichnet die Erfindung, dass zwischen Aufstellfläche (6) und Förderer (7) mehrfach und/oder dass zwischen Förderer (7) und Halter (5) mindestens zweifach ein schwingungsdämpfendes Lager (9, 10) derart vorgesehen ist, dass von der Aufstellfläche (6) ausgehende kritische Schwingungen gedämpft werden, wobei das Lager (9, 10) eine vorgebbare Lagerschwingung ausführend ausgebildet ist und wobei die Lager über Leitungsverbindungen mit mindestens einem pneumatischen Schwingungsgenerator verbunden sind; Fig. 1.

## Beschreibung

Die Erfindung betrifft den Unterbau und insbesondere die Lagerung für eine Apparatur zur Substratbehandlung. Die Apparatur ist aufgrund derer Wirkungsweise insofern stoßempfindlich, dass sich bei Schwingungen oder Stößen die substratbehandelnde Wirkung verzerrt, verfälscht oder zumindest unpräzise am Substrat niederschlägt. Derartige Probleme treten beispielsweise dort auf und lassen sich durch die Erfindung beheben, wo die Substratbehandlung mit fokussiertem Licht erfolgt.

Das Anwendungsgebiet der Erfindung betrifft die Behandlung großflächiger vorrangig flacher Substrate wie Glasscheiben, Kunststofffolien und Metallbänder, die im Zuge ihrer Behandlung eine Beschichtung erfahren. So lassen sich Beschichtungen für Architekturgläser und Photovoltaik sowie solche mit hochgradiger Reflexion oder Absorption schaffen. Vorstehendes erfolgt üblicherweise mittels Anlagen zur Vakuumbehandlung. Die die Erfindung betreffende Apparatur kommt derzeit vorrangig nachfolgend der Vakuumbehandlung zum Einsatz und das unter Normalbedingungen an Luft.

Aus DE 10 2006 047 472 A1 ist beispielhaft eine solche Behandlung mit kurzwelliger elektromagnetischer Strahlung bekannt, die auf großflächige Substrate angewandt wird.

Es handelt sich bei der Substratbehandlung mit fokussiertem bzw. hochfokussiertem Licht im Detail um eine solche, die vormaliges RTP (rapid thermal processing) insofern verbessert, dass diese Behandlung nicht mittels infraroter Strahlung sondern mit hochfokussiertem Licht wie optisch gebündeltem Laserlicht oder Blitzlampen durchgeführt wird, was eine vorteilhafte Form der Substratbehandlung möglich macht. Das Licht wirkt mit hoher Energiedichte jedoch mit kurzer Verweildauer auf das Substrat ein, sodass die thermische Wirkung nahe der äußersten Schicht auf dem Substrat verbleibt. Die erzielbaren Effekte lassen deutliche Vorzüge in der Gestaltung von Schichteigenschaften erkennen, da sich Nebenwirkungen durch Substraterwärmung wie beispielsweise Diffusion vermindert auswirken.

Ein Verfahren zur Herstellung eines beschichteten Gegenstandes ist unter anderem aus DE 10 2009 033 417 A1 bekannt, wobei der beschichtete Gegenstand (Substrat) mittels Laser behandelt wird. Bei den gezeigten Vorrichtungen handelt es sich auch um solche, die zum Anwendungsgebiet der Erfindung gehören.

Problemursächlich kommen zwei noch im Detail ausgeführte wesentliche Aspekte in Betracht. Erstens sollen neuerlich besagte Apparaturen zur großflächigen Substratbehandlung eingesetzt werden, die jedoch empfindlich gegen jedwede Erschütterungen und Schwingungen sind. Zum Zweiten sind Anlagen zur Substratbehandlung zumeist in Werkhallen und solche in Werksgeländen vorzufinden, wo grobmotorische Technik im Einsatz ist. Letzteres meint Mittel zum Transport wie beispielsweise Gabelstapler, Mittel zur Glasfertigung wie eine Floatglasanlage, Mittel zur Vakuumbehandlung wie eine Durchlaufbeschichtungsanlage inklusive Schleusen, Mittel zur Entsorgung wie Glasbrecher sowie Pumpen, Aggregate, elektrische Transformatoren, Gebläse und vieles Ähnliches mehr.

Kritische Schwingungen, was begrifflich Erschütterungen einbezieht, sind solche, dass ausgehend von einer fokussierten Lichtquelle jedweder Art und einschließlich Laser der von der Quelle ausgesandte Strahl am auftreffenden Ziel, dem Substrat, eine oszillierende Bewegung beschreibt. Diese Bewegung ist bereits kritisch, wenn sie Bruchteile von Mikro-, Milli- oder Sekunden andauert und auch dann, wenn die vollzogene Bewegung des Strahles auf dem Substrat, hier Amplitude, über wenige Mikrometer erfolgt. Zusammengenommen trifft damit der vormals an der Quelle fokussierte Strahl aufgrund der Schwingungen im zeitlichen Verlauf defokussiert am Substrat auf, was seine Wirkung bezüglich eines Energieeintrages auf die substratäußerste Fläche inhomogen macht. Als inhomogen ist bei solchen Energiedichten bereits eine Abweichung von 1 % und weniger pro Flächeneinheit einzustufen. Mit substratäußerster Fläche ist die Außenfläche des Substrates, hier Substrataußenfläche, gemeint, was die Oberfläche des Festkörpers, der das Substrat umfasst oder einschließt, ist; ohne beziehungsweise mit auf dem Substrat aufgetragenen Schichten. Bei der zu behandelnden Substrataußenfläche ist hier von der Behandlungsfläche die Rede.

Solches ist bei Apparaturen der Fall, wo sich Quelle und Substrat im Abstand zwischen ca. 2cm und 30cm zueinander befinden. Weiterhin betrifft dieser Effekt nicht primär den punktförmig auftreffenden Stahl sondern vielmehr so genannte Linienlichtquellen, die hochfokussiert dafür vorgesehen sind, einen linienförmigen Abschnitt eines Substrates zu behandeln, was hier als Lichtstrich bezeichnet wird.

In DE 10 2007 052 782 A1 ist ein Verfahren zur Substratbehandlung mittels Laserlicht, das eine linienförmige Intensitätsverteilung auf dem Substrat ausbildet, beschrieben. Vorgesehen ist die Behandlung einer TCO-Schicht, um insbesondere deren elektrische und/oder optische Eigenschaften zu verbessern.
Dieser Lichtstrich nach hiesiger Definition ist mit einer Breite zwischen 10µm und 100µm sowie mit einer Länge bis zu 3,30m vorgesehen. Energiedichten, die zwischen 1 KW/cm² und 1000KW/cm² liegen können, sind dazu vorgeschlagen.

Im gattungsgemäßen Umfeld der Erfindung, kommt die vorstehend beschriebene Lösung in Betracht als auch weitere, bei denen von einer Lichtquelle aus, das Licht hochfokussierte, d.h. mit einer wie beschrieben hohen Energiedichte angewandt wird, und bei denen sich die Lichtquelle im beschriebenen Abstand zum Substrat befindet. Dann nämlich wirken sich besagte kritische Schwingungen nachteilig auf das Ergebnis der Substratbehandlung aus.

Den vorstehenden problematischen Bedingungen kommt hinzu, dass das Substrat kontinuierlich vorbei an der behandelnden Quelle und damit relativ zu dieser bewegt wird, um quasi den behandelnden Lichtstrich über das Substrat zu ziehen.
Die Quelle ist üblicherweise derart feststehend positioniert, dass der Lichtstrich quer über das Substrat verläuft, wobei das Substrat auf einem Transportpfad in Transportrichtung bewegt wird.
Zurück kommend auf die kritischen Schwingungen sind diese weniger kritisch, wenn sich dadurch der Lichtstrich ausschließlich quer zur Transportrichtung des Substrats bewegt. In allen übrigen Fällen kommt es jedoch zu besagten Abweichungen bezüglich der Homogenität des Energieeintrages pro Flächeneinheit; hier Flächenhomogenität. Anders gesagt, kann der Energieeintrag vorrangig in Transportrichtung derart schwingen, dass sich in Anbetracht des kontinuierlichen Substrattransports auf dem Substrat in Transportrichtung besagte Flächenhomogenität auftreten. Dem scheint derzeit nur durch geeignete Mittel der Schwingungsdämpfung etwas entgegen zu setzen sein.

Aus dem Stand der Technik sind im Bereich der Anlagentechnik für die Vakuumbehandlung allgemein schwingungsdämpfende Standfüße wie solche mit Gummilagerung bekannt. Um derartige Anlagen bei Erdbeben bezüglich ihrer Standfestigkeit zu verbessern, zeigt DE 20 2011 108 355 U1 eine Lösung auf.

Ansonsten regen Lösungen aus entfernten technischen Gebieten u.a. Vorrichtungen an, die mittels mechanischer Federelemente oder Dergleichen eine zügige Dämpfung der Schwingung herbeiführen. Es zeigen jeweils DE 198 51 255 C2 einen Seismischen Isolator für einen Schaukasten, DE 196 15 430 C1 einen Schaltschrank und DE 195 43 195 A1 ein schockabsorbierendes Fundament insbesondere für Gebäude. Angesichts besagter Sensibilität von Behandlungsverfahren mittels Lichtlinie scheidet aus dem Stand der Technik Bekanntes zunächst aus.

Es ist auch durchaus bekannt, dass hochsensible Messinstrumente wie beispielsweise Mikroskope auf massiven und schweren Platten erschütterungsgedämpft gelagert werden, nur bietet solches den vermeintlichen Anforderungen nach bester Flächenhomogenität bei besagten Behandlungsverfahren zumindest nicht im angemessenen Verhältnis von Aufwand und Nutzen eine Lösung. Es ließen sich besagte kritische Schwingungen, mit geringer Frequenz und Amplitude, somit kaum unterdrücken.

Zudem sind beispielsweise aus JP 2007 072 267 A Vorrichtungen zur Substratbehandlung mit optischen Mitteln bekannt. Es handelt sich jeweils um eine solche Vorrichtung, in der das Substrat in eine Position gebracht, auf einer Unterlage fixiert, die Unterlage ausgerichtet und das Substrat z.B. mittels Masken- oder Fotolithographie belichtet wird. Vorgesehene Rollen dienen dem Zu- und Abtransport der Substrate oder von Substratträgern. Ein Belichtungsgerät belichtet bei ruhendem Substrat und nicht bei einem kontinuierlichen Substrattransport. Es ist ohne die nähere Angabe von Mitteln zur Dämpfung gesagt, dass das Substrat ohne Vibration zu stabilisieren ist.

Aus der Druckschrift DE 39 17 408 A1 geht ein Dämpfungssockel für einen Gerätetisch hervor, der in der Halbleiterproduktion ggf. mit Lasereinsatz Verwendung finden kann. Ein Bezug zu Substraten, zu einem kontinuierlichen Substrattransport, zur Substratbehandlung bei einem kontinuierlichen Substrattransport und zur Substratbehandlung mit einem hochfokussierten Lichtstrich usw. lässt sich zunächst nicht ohne weiteres herstellen. Die zur Schwingungsdämpfung vorgesehen Lufttanks fungieren als passive Dämpfer. Der Gerätetisch ist beweglich ausgeführt und mit Linearmotoren bewegbar.

Hinlänglich bekannte Mittel zur Dämpfung kritischer Schwingungen lassen sich auch aus DE 10 2004 011 896 A1, aus DE 10 2004 052 843 A1 und aus DE 41 33 037 A1 entnehmen.

Es ist das Ziel der Erfindung, besagte kritische Schwingungen, die ursächlich von der Standfläche einer Apparatur herrühren, weitestgehend so zu unterdrücken, dass in der Apparatur die Lichtquelle für hochfokussiertes Linienlicht sowie das Substrat lagestabil gegenüber störenden Schwingungen behandelbar ist.

Der Erfindung liegt die Aufgabe zugrunde, eine Apparatur mit einer verbesserten Lagerung zu schaffen, die die bislang bekannten Probleme überwindet.

Diese Aufgabe löst die Erfindung mit einer Apparatur gemäß Patentanspruch 1 sowie mit einem adäquaten Verfahren gemäß Patenanspruch 11.
Vorteilhafte Ausgestaltungsformen der Erfindung zeigen Unteransprüche auf.

Die gattungsgemäße Apparatur zur Substratbehandlung mit einem hochfokussierten Lichtstrich weist mindestens eine Lichtquelle zum Erzeugen des Lichtstriches auf einer der Substrataußenflächen, bezeichnet als Behandlungsfläche, einen Abstand zwischen Lichtquelle und Substrat auf. Die Apparatur weist ferner
die Lichtquelle, einen Halter der Lichtquelle für den Abstand zum Substrat und einen für einen kontinuierlichen Substrattransport vorgesehenen Förderer auf. Mittels des Förderers ist das Substrat relativ zum Lichtstrich in Transportrichtung bewegbar und der Förderer ist gegenüber einer Aufstellfläche für die Apparatur sowie der Halter gegenüber dem Förderer vertikal abgestützt.

Es kennzeichnet die Apparatur als erfindungswesentlich, dass zwischen Aufstellfläche und Förderer mehrfach und/oder dass zwischen Förderer und Halter mindestens zweifach ein schwingungsdämpfendes Lager derart vorgesehen ist, dass von der Aufstellfläche ausgehende kritische Schwingungen gedämpft werden, wobei das Lager eine vorgebbare Lagerschwingung ausführend ausgebildet ist und wobei die Lager über Leitungsverbindungen mit mindestens einem pneumatischen Schwingungsgenerator verbunden sind.

Mit anderen Worten gesprochen sind so genannte tragende Baugruppen auf Lager, die selbsttätig schwingen, aufzustellen. Die Lagerschwingung kann vorzugsweise vertikal, aber auch horizontal sowie nach einer beliebigen vektoriellen Kombination ausgerichtet sein.

In weiterer Ausgestaltung der Erfindung ist das Aufstelllager zwischen Aufstellfläche und Förderer eine erste Lagerschwingung aufweisend ausgebildet.

In weiterer Ausgestaltung der Erfindung ist das Halterlager zwischen Förderer und Halter eine zweite Lagerschwingung aufweisend ausgebildet.

In weiterer Ausgestaltung der Erfindung sind Lager nach Lagerschwingungen gruppiert mit Schwingungsgeneratoren verbunden.

In weiterer Ausgestaltung der Erfindung weisen die mit einem ersten Schwingungsgenerator verbundenen Aufstelllager mit der ersten Lagerschwingung und die mit einem zweiten Schwingungsgenerator verbundenen Halterlager mit der zweiten Lagerschwingung derartige Lagerschwingungen, die zueinander in der Frequenz um 180° phasenverschoben sind, auf, sodass sich Interferenzen einstellen.

In weiterer Ausgestaltung der Erfindung weisen Lager derartige Lagerschwingungen, dass diese jeweils die Eigenfrequenz von Förderer und/oder Halter kompensieren, auf.

In weiterer Ausgestaltung der Erfindung ist die Lagerschwingung im Bereich von 10Hz bis 30Hz vorgesehen.

In weiterer Ausgestaltung der Erfindung sind Mittel zum Erfassen von Eigen- und/oder Störschwingungen und Mittel zum Einstellen von Lagerschwingungen vorgesehen.

In weiterer Ausgestaltung der Erfindung weist der Förderer Rollen auf, die auf einer Aufspannplatte aus Gussstahl befestigt sind.

In weiterer Ausgestaltung der Erfindung ist mindestens ein Lager in dessen Dämpfung pneumatisch einstellbar vorgesehen.

Das gattungsgemäße Verfahren zur Lagerung einer stoßempfindlichen Apparatur zur Substratbehandlung mit einem hochfokussierten Lichtstrich wird ausgeführt mit der Apparatur, die mindestens eine Lichtquelle zum Erzeugen des Lichtstriches auf einer der Substrataußenflächen, bezeichnet als Behandlungsfläche, einen Abstand zwischen Lichtquelle und Substrat aufweist. Die Apparatur weist ferner die Lichtquelle, einen Halter der Lichtquelle für den Abstand zum Substrat und einen für einen kontinuierlichen Substrattransport vorgesehenen Förderer auf. Mittels des Förderers wird das Substrat relativ zum Lichtstrich in Transportrichtung bewegt und der Förderer wird gegenüber einer Aufstellfläche für die Apparatur sowie der Halter gegenüber dem Förderer vertikal gestützt.

Es kennzeichnet das Verfahren als erfindungswesentlich, dass zwischen Aufstellfläche und Förderer mehrfach und/oder dass zwischen Förderer und Halter mindestens zweifach ein schwingungsdämpfendes Lager derart vorgesehen ist, dass von der Aufstellfläche ausgehende kritische Schwingungen gedämpft werden, wobei das Lager eine vorgebbare Lagerschwingung ausführt und wobei die Lagerschwingungen von mindestens einem pneumatischen Schwingungsgenerator erzeugt und den Lagern über Leitungsverbindungen bereitgestellt werden.

In weiterer Ausgestaltung der Erfindung wird eine Eigenschwingung von Förderer und/oder Halter jeweils anliegend am Lagerkopf derart, dass die Lagerschwingung eines Lagers wie die Eigenschwingungen in der Frequenz um 180° phasenverschoben und mit vorzugszugsweise gleicher Amplitude angeregt wird, bis zum Lagerfuß durch Interferenz kompensiert.

In weiterer Ausgestaltung der Erfindung wird eine Störschwingung ausgehend von der Aufstellfläche und/oder vom Förderer jeweils anliegend am Lagerfuß derart, dass die Lagerschwingung eines Lagers wie die Störschwingung in der Frequenz um 180° phasenverschoben und mit vorzugszugsweise gleicher Amplitude angeregt wird, bis zum Lagerkopf durch Interferenz kompensiert.

Die Vorteile der Erfindung darstellend liegt eine erste wesentliche Neuerung in den Lagern, die eine angeregte Lagerschwingung ausführen. Mit der Einstellbarkeit der Lagerschwingung gelingt es weiter, die vorrangig permanent vorhandenen Schwingungen, also Eigenschwingungen der Aufstellfläche und/oder des Förderers jeweils gegenüber dem Förderer beziehungsweise gegenüber dem Träger zu kompensieren. Letztendlich wird dadurch eine Schwingung der Lichtquelle besser als bislang vermieden. Auch der Förderer ist deutlich geringeren Schwingungen ausgesetzt, wodurch implizit relative Schwingungen zwischen Lichtquelle und Substrat in verminderter Intensität vorzufinden sind. Das wiederum verbessert die Qualität der Substratbehandlung mit dem Lichtstrich.

Für die Aufstellfläche kommt primär der Hallenboden in Frage, wobei anstatt des Hallenbodens auch eine Art Arbeitstisch oder der Boden eines Kammergehäuses denkbar wäre. Beim Förderer sind angesichts besagter Substratformen wie Glasscheiben so genannte Rollenförderer von Vorteil. Diese wiesen schon durch die Antriebe und durch die Drehbewegung der Rolle solche Eigenschwingungen auf, die sich im besagten Anwendungsfall mindern lassen. Vorteilhafterweise ist der Förderer mit einer solchen Aufspannplatte ausgestattet, dass durch Festspannmittel die Montage der Rollen vereinfacht wird. Ist die Aufspannplatte aus Guss gefertigt und das so, dass deren Gewicht dem Förderer ein hohes Maß an Trägheit verleiht, wirken sich Erschütterungen weitaus geringer aus. Die Gussplatte in der Kombination mit den Lagern bietet eine vorteilhafte Konfiguration zur Kompensation von Erschütterung, so genannten Störschwingungen.

Die Wirksamkeit der Idee wird nunmehr dadurch weiter angehoben, dass mehrere Lager gekoppelt eine Schwingung vorziehen, dass sich Gruppen bilden lassen und zwar die Gruppe der Aufstelllager und die der Halterlager und dass sich so ganz gezielt der Effekt der Interferenz einstellen lässt.
Das wiederum muss nicht zwingend mit Mess- und Regeltechnik erfolgen, sondern lässt sich auch mit Hilfe von Prüfmitteln so fest vorgeben und manuell einstellen, dass an Förderer und Träger das geringste Maß an Schwingungen nachweisbar ist.
Einstellbar ist die Dämpfung in den Lagern sowie Frequenz und Phase des pneumatischen Schwingungsgenerators vorgesehen, was eine Art Kreiselpumpe sein kann. Die Dämpfung ist insofern pneumatisch zu beeinflussen, dass an einer Art Federbalg im Lager ein definierter Innendruck anliegt.

Das aufgezeigte Verfahren verdeutlicht die Arbeitsweise der Apparatur insbesondere mit dem Fokus auf die Kompensation mittels Interferenz. Es dürfte sich als besonders wirksam zeigen, die Lagerschwingung der Halterlager diesbezüglich einzustellen.

Ein abschließender Gedanke ist der, dass die Lagerschwingungen nicht zwingend ausschließlich vertikal erfolgen müssen, wenn auch derzeit darin ein tragender Effekt. Möglichweise könnte eine Mischung aus Schwingungen zu einer komplexen Lagerschwingung in den drei translatorischen Freiheitsgraden (x, y, z) führen, dass sich zumindest Erschütterungen noch besser kompensieren lassen.

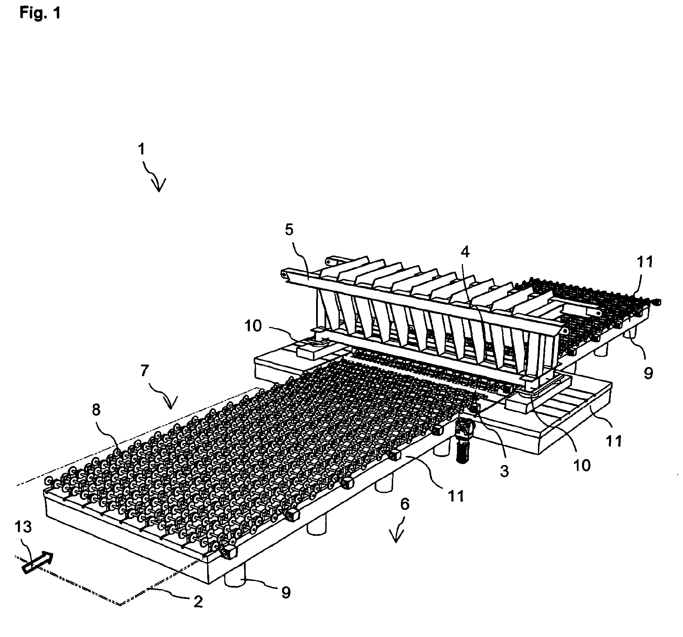

Nachfolgend soll die Erfindung anhand eines Ausführungsbeispiels näher beschrieben werden. Dazu zeigt die Fig. 1 die Apparatur 1, die beispielsweise so in den Transportpfad einer Vakuumbeschichtungsanlage integriert sein könnte, dass dort, wo die Substrate 2 die Anlage in Transportrichtung 13 verlassen, die Apparatur 1 aufgestellt wäre. Das Substrat 2 wird mittels des Förderers 7 transportiert, wobei es auf den Rollen 8 aufliegend unter dem Halter 5 für die Lichtquelle 4 hindurch bewegt wird. Dabei trifft auf die Behandlungsfläche der Lichtstrich 3 auf. Mit Aufspannplatte 11 werden in der Fig. drei Teile bezeichnet, weil die Aufspannplatte 11 zwar dreiteilig ausgeführt ist, aber letztlich durch die miteinander verbundenen Teile ein Ganzes bildet. Das ist bei der Aufspannplatte 11 insofern wichtig, da deren Masse von Vorteil ist. Daher ist die Aufspannplatte 11 aus zumindest 3cm und bis 10cm dicken Guss gefertigt. Die erfindungswesentlichen Lager 9 und 10 befinden sich dem Prinzip nach an zwei Positionen. Zum Ersten sind die Aufstelllager 9 zwischen Aufstellfläche 6 und der Aufspannplatte 11, was letztlich der Förderer 7 ist, und zum Zweiten die Halterlager 10 zwischen der Aufspannplatte 11 des Förderers 7 und dem Halter 5 vorgesehen. Für die vorteilhafte Wirkungsweise der Apparatur 1 schwingen die Lager 9 und 10 in der beschrieben Art und Weise beziehungsweise sind die Lager so ausgeführt, dass diese mittels hier nicht dargestellten Schwingungsgeneratoren über Verbindungsleitungen aktiv zum Schwingen gebracht werden können.
Ein solches Lager könnte beispielsweise aus einem zweiteigen Gehäuse bestehen, wobei die Teile Lagerfuß und Lagerkopf bilden. Beide sind federnd miteinander verbunden und im Inneren des Gehäuses verbindet ein Balg beide federnd gelagerten Gehäuseteile. Der mit einer Flüssigkeit gefüllte Balg ist mit einem Anschluss für mindestens eine Verbindungsleitung ausgestattet.

### Bezugszeichenliste

- 1: Apparatur
- 2: Substrat
- 3: Lichtstrich
- 4: Lichtquelle
- 5: Halter
- 6: Aufstellfläche
- 7: Förderer
- 8: Rollen
- 9: Aufstelllager
- 10: Halterlager
- 11: Aufspannplatte
- 12: Abstand
- 13: Transportrichtung

## Patentansprüche

1. Apparatur (1) zur Substratbehandlung mit einem hochfokussierten Lichtstrich (3), die Apparatur (1) aufweisend
mindestens eine Lichtquelle (4) zum Erzeugen des Lichtstriches (3) auf einer der Substrataußenflächen, bezeichnet als Behandlungsfläche,
einen Abstand (12) zwischen Lichtquelle (4) und Substrat (2),
die Lichtquelle (4) und einen Halter (5) der Lichtquelle (4) für den Abstand (12) zum Substrat (2) und
einen für einen kontinuierlichen Substrattransport vorgesehenen Förderer (7), wobei mittels des Förderers (7) das Substrat (2) relativ zum Lichtstrich (3) in Transportrichtung (13) bewegbar ist und
wobei der Förderer (7) gegenüber einer Aufstellfläche (6) für die Apparatur (1) sowie der Halter (5) gegenüber dem Förderer (7) vertikal abgestützt ist,
**dadurch gekennzeichnet,**
**dass** zwischen Aufstellfläche (6) und Förderer (7) mehrfach und/oder dass zwischen Förderer (7) und Halter (5) mindestens zweifach ein schwingungsdämpfendes Lager (9, 10) derart vorgesehen ist" dass von der Aufstellfläche (6) ausgehende kritische Schwingungen gedämpft werden, wobei das Lager (9, 10) eine vorgebbare Lagerschwingung ausführend ausgebildet ist und wobei die Lager (9, 10) über Leitungsverbindungen mit mindestens einem pneumatischen Schwingungsgenerator verbunden sind.

2. Apparatur nach Anspruch 1, **dadurch gekennzeichnet, dass** das Aufstelllager (9) zwischen Aufstellfläche (6) und Förderer (7) eine erste Lagerschwingung aufweisend ausgebildet ist.

3. Apparatur nach Anspruch 1 oder 2, **dadurch gekennzeichnet, dass** das Halterlager (10) zwischen Förderer (7) und Halter (5) eine zweite Lagerschwingung aufweisend ausgebildet ist.

4. Apparatur nach einem der Ansprüche 1 bis 3, **dadurch gekennzeichnet, dass** Lager (9, 10) nach Lagerschwingungen gruppiert mit Schwingungsgeneratoren verbunden sind.

5. Apparatur nach einem der Ansprüche 1 bis 4, **dadurch gekennzeichnet, dass** die mit einem ersten Schwingungsgenerator verbundenen Aufstelllager (9) mit der ersten Lagerschwingung und
die mit einem zweiten Schwingungsgenerator verbundenen Haltedager (10) mit der zweiten Lagerschwingung derartige Lagerschwingungen, die in der Frequenz um 180° phasenverschoben sind, aufweisen,
sodass sich Interferenzen einstellen.

6. Apparatur nach einem der Ansprüche 1 bis 5, **dadurch gekennzeichnet, dass** Lager (9, 10) derartige Lagerschwingungen, dass diese jeweils die Eigenfrequenz von Förderer (7) und/oder Halter (5) kompensieren, aufweisen.

7. Apparatur nach einem der vorhergehenden Ansprüche, **dadurch gekennzeichnet, dass** die Lagerschwingung im Bereich von 10Hz bis 30Hz vorgesehen ist.

8. Apparatur nach einem der vorhergehenden Ansprüche, **dadurch gekennzeichnet, dass** Mittel zum Erfassen von Eigen- und/oder Störschwingungen und Mittel zum Einstellen von Lagerschwingungen vorgesehen sind.

9. Apparatur nach einem der vorhergehenden Ansprüche, **dadurch gekennzeichnet, dass** der Förderer (7) Rollen (8) aufweist, die auf einer Aufspannplatte (11) aus Gussstahl befestigt sind.

10. Apparatur nach einem der vorhergehenden Ansprüche, **dadurch gekennzeichnet, dass** mindestens ein Lager (9, 10) in dessen Dämpfung pneumatisch einstellbar vorgesehen ist.

11. Verfahren zur Lagerung einer stoßempfindlichen Apparatur (1) zur Substratbehandlung mit einem hochfokussierten Lichtstrich (3),
die Apparatur (1) aufweisend
mindestens eine Lichtquelle (4) zum Erzeugen des Lichtstriches (3) auf einer der Substrataußenflächen, bezeichnet als Behandlungsfläche,
einen Abstand (12) zwischen Lichtquelle (4) und Substrat (2),
die Lichtquelle (4) und einen Halter (5) der Lichtquelle (4) für den Abstand (12) zum Substrat (2) und
einen für einen kontinuierlichen Substrattransport vorgesehenen Förderer (7),
wobei mittels des Förderers (7) das Substrat (2) relativ zum Lichtstrich (3) in Transportrichtung (13) bewegt wird und
wobei der Förderer (7) gegenüber einer Aufstellfläche (6) für die Apparatur (1) sowie der Halter (5) gegenüber dem Förderer (7) vertikal gestützt wird,
**dadurch gekennzeichnet,**
**dass** zwischen Aufstellfläche (6) und Förderer (7) mehrfach und/oder dass zwischen Förderer (7) und Halter (5) mindestens zweifach ein schwingungsdämpfendes Lager (9, 10) derart vorgesehen ist, dass von der Aufstellfläche (6) ausgehende kritische Schwingungen gedämpft werden,
wobei das Lager (9, 10) eine vorgebbare Lagerschwingung ausführt und
wobei die Lagerschwingungen von mindestens einem pneumatischen Schwingungsgenerator erzeugt und den Lagern (9, 10) über Leitungsverbindungen bereitgestellt werden.

12. Verfahren nach Anspruch 11, **dadurch gekennzeichnet, dass** eine Eigenschwingung von Förderer (7) und/oder Halter (5) jeweils anliegend am Lagerkopf derart,
dass die Lagerschwingung eines Lagers (9, 10) wie die Eigenschwingungen in der Frequenz um 180° phasenverschoben und mit vorzugszugsweise gleicher Amplitude angeregt wird, bis zum Lagerfuß durch Interferenz kompensiert wird.

13. Verfahren nach Anspruch 11 oder 12, **dadurch gekennzeichnet, dass** eine Störschwingung ausgehend von der Aufstellfläche (6) und/oder vom Förderer (7) jeweils anliegend am Lagerfuß derart,
dass die Lagerschwingung eines Lagers (9, 10) wie die Störschwingung in der Frequenz um 180° phasenverschoben und mit vorzugszugsweise gleicher Amplitude angeregt wird, bis zum Lagerkopf durch Interferenz kompensiert wird.
